# EUROPEAN PATENT APPLICATION

(11) **EP 2 879 473 A1**
(43) Date of publication of application: **03.06.2015**
(21) Application number: 13883651.5
(22) Date of filing: 18.10.2013
(51) Int. Cl.: H05K 7/00

(54) **RACK FOR A COMPUTER ENGINEERING APPARATUS**

(30) Priority: 30.04.2013 RU 2013120108
(71) Applicant: Obschesctvo S Ogranichennoy Otvetstvennostyu "Depo Electronics", Moskovskaya obl. 143400 (RU)
(72) Inventor: ESKIN, Sergei Vadimovich, Solnechnogorskiy rayon Moskovskaya obl. 141544 (RU)
(74) Representative: Flügel Preissner Kastel Schober
(86) International application number: PCT/RU2013/000923
(87) International publication number: WO 2014/178752

(57) **Abstract**

The utility model is relative to computer engineering and may be used for construction of different racks intended for disposal of communications-electronics equipment. The technical result archived through usage of proposed utility model is reduction of energy consumption due to improvement of rack's configuration.

The rack for equipment of computer engineering, which presents to be a metal cabinet composed of front and rear frames connected with load-bearing elements in the form of horizontal beams, horizontal and vertical panels, 19" profiles and trays for installation of unified computing units, cooling system, which includes fans and air duct inside the aforementioned cabinet, and commutation facilities. The cabinet has front sealing elements placed between 19" profiles and the frame. There is also an adjustable apron in the lower part. The front sealing is furnished with slit windows along the whole operational height, which are intended for laying of signal and power supply cables. These windows are covered with brushes or plugs. The front frame is accommodated with mounting seats for installation of vertical organizer's rings with depth from 20 to 90 mm. The aforementioned horizontal beams of the cabinet are fitted with windows as well to use them as additional cable channels allowing to distribute cables in horizontal and vertical planes. There are slide fixable cable inlets on upper panel of the cabinet. There are vertical profiles on the back of the cabinet for simultaneous mount of power distributors and fixation of power and other cables. The fans are located on the level of the rack itself, while commutation facilities installed in the front part of the cabinet. The middle part of the cabinet accommodates free space for placing of common pool of power supply units.

## Description

The utility model is relative to computer engineering and may be used for construction of different racks intended for disposal of communications-electronics equipment, presumably means of computer engineering, namely server equipment of internet service provider.

The existing server solutions do not meet the number of requirements demanded by customers of ISP segment due to the excessiveness of configuration regarding embedded subsystems (computing unit, cooling, power supply), which alone influences the budget of the project on the stage of equipment procurement already. Besides, usage of non-optimized configurations leads to additional expenses for power supply and cooling of existing subsystems during operating and complicating of maintenance.

The closest analogue of the utility model is the rack for equipment of computer engineering, which contains metal cabinet composed of front and rear frames connected with load-bearing elements in the form of horizontal beams, horizontal and vertical panels, 19" profiles and trays for installation of unified computing units, cooling system, which includes fans and air duct inside the aforementioned cabinet, and commutation facilities as well (USSR author's certificate Nº 1667277, N 05 K 7/00, published on the 30th of July 1991).

The technical problem, which is intended to be resolved through the development of the present utility model, implies creation of specified rack solution for disposal of electronic equipment capable to increase energy effectiveness due to optimal distribution of power supply cables and means of cooling.

The technical result archived through usage of proposed utility model is reduction of energy consumption due to improvement of rack's configuration.

The technical result is archived by unique configuration of the rack for equipment of computer engineering, which presents to be a metal cabinet composed of front and rear frames connected with load-bearing elements in the form of horizontal beams, horizontal and vertical panels, 19" profiles and trays for installation of unified computing units, cooling system, which includes fans and air duct inside the aforementioned cabinet, and commutation facilities. The cabinet has front sealing elements placed between 19" profiles and the frame. There is also an adjustable apron in the lower part. The front sealing is furnished with slit windows along the whole operational height, which are intended for laying of signal and power supply cables. These windows are covered with brushes or plugs. The front frame is accommodated with mounting seats for installation of vertical organizer's rings with depth from 20 to 90 mm. The aforementioned horizontal beams of the cabinet are fitted with windows as well to use them as additional cable channels allowing to distribute cables in horizontal and vertical planes. There are slide fixable cable inlets on upper panel of the cabinet. There are vertical profiles on the back of the cabinet for simultaneous mount of power distributors and fixation of power and other cables. The fans are located on the level of the rack itself, while commutation facilities installed in the front part of the cabinet. The middle part of the cabinet accommodates free space for placing of common pool of power supply units.

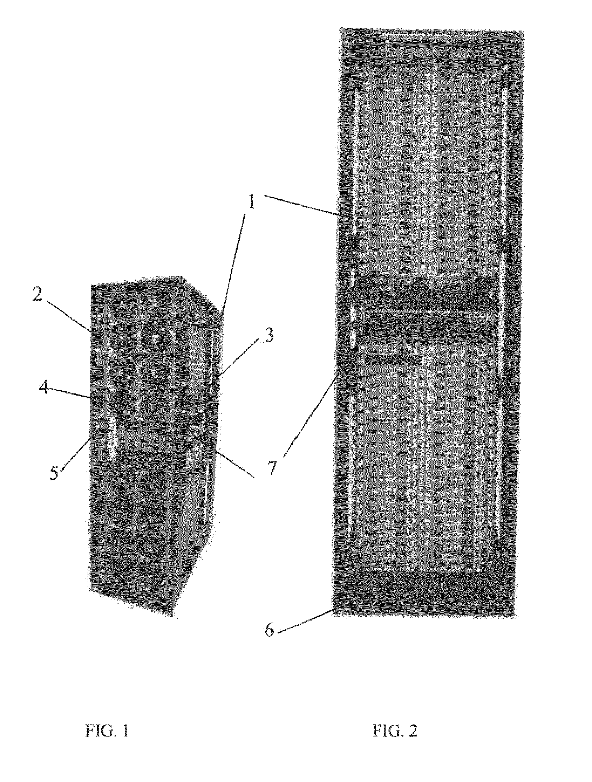

Graphical materials represent general view of proposed utility model in front (Fig.1) and from the back (Fig. 2).

The rack for equipment of computer engineering presents to be a metal cabinet. Front and rear frames land 2 are connected with load-bearing elements in the form of horizontal beams 3. There are horizontal and vertical panels, 19" profiles and trays for installation of unified computing units, cooling system, which includes fans 4 and air duct 5 inside the aforementioned cabinet. Commutation facilities (USB, LAN and etc.) are located in the front part of the cabinet. The cabinet has front sealing elements placed between 19" profiles and the frame 1. There is also an adjustable apron 6 in the lower part. The front sealing is furnished with slit windows along the whole operational height, which are intended for laying of signal and power supply cables. These windows are covered with brushes or plugs. The front frame 1 is accommodated with mounting seats for installation of vertical organizer's rings with depth from 20 to 90 mm. The horizontal beams of the cabinet are fitted with windows to use them as additional cable channels allowing to distribute cables in horizontal and vertical planes. There are slide fixable cable inlets on upper panel of the cabinet. There are vertical profiles on the back of the cabinet for simultaneous mount of power distributors and fixation of power and other cables. The fans 4 are located on the level of the rack itself, while commutation facilities installed in the front part of the cabinet. The middle part of the cabinet accommodates free space for placing of common pool of power supply units 7.

Common ventilation of computing units and common power supply (single bus) are provided. The system is a "construction kit" composed of standard elements:
Server cabinet
Trays for mounting of typical motherboards and hard disks
Management server
Common power bus
Common control bus
Common cooling system
Common pool of power supply units

Quick replacement of unit in case of necessity is provided due to organization of front maintenance: network and other connectors are located on the front panel.

General cooling of the whole system is provided by air gap between fans and computing units.

Power supply units from the common pool can have different ratings depending on power consumption of certain rack.

Efficiency if cooling system is increased due to removing of fans from the servers and placing them on the level of the rack.

## Claims

1. The rack for equipment of computer engineering, which presents to be a metal cabinet composed of front and rear frames connected with load-bearing elements in the form of horizontal beams, horizontal and vertical panels, 19" profiles and trays for installation of unified computing units, cooling system, which includes fans and air duct inside the aforementioned cabinet, and commutation facilities. The cabinet has front sealing elements placed between 19" profiles and the frame. There is also an adjustable apron in the lower part. The front sealing is furnished with slit windows along the whole operational height, which are intended for laying of signal and power supply cables. These windows are covered with brushes or plugs. The front frame is accommodated with mounting seats for installation of vertical organizer's rings with depth from 20 to 90 mm. The aforementioned horizontal beams of the cabinet are fitted with windows as well to use them as additional cable channels allowing to distribute cables in horizontal and vertical planes. There are slide fixable cable inlets on upper panel of the cabinet. There are vertical profiles on the back of the cabinet for simultaneous mount of power distributors and fixation of power and other cables. The fans are located on the level of the rack itself, while commutation facilities installed in the front part of the cabinet. The middle part of the cabinet accommodates free space for placing of common pool of power supply units.

2. Rack in section 1 is different due to usage of porous polymer as sealing,
